# EUROPEAN PATENT APPLICATION

(11) **EP 2 908 201 A1**
(43) Date of publication of application: **19.08.2015**
(21) Application number: 15153621.6
(22) Date of filing: 03.02.2015
(51) Int. Cl.: G05B 19/4097

(54) **CAM and NC code integration**

(30) Priority: 03.02.2014 US 201414170762
(71) Applicant: Siemens Aktiengesellschaft, 80333 München (DE); Siemens Product Lifecycle Management Software Inc., Plano, TX 75024-6612 (US)
(72) Inventor: Stolper, Thilo, 70191 Stuttgart (DE); Diezel, Matthias, 90482 Nürnberg (DE); Schenk, Bernhard, 90537 Feucht (DE); Fürst, Johannes, 85356 Freising (DE); Madeley, David, Louth, Lincolnshire LN11 8QY (GB)
(74) Representative: Isarpatent

(57) **Abstract**

Methods for systems and methods for integrating and linking of NC-machine operations and programming modifications to the CAM system (200) and the CAM model (208), and corresponding systems and computer-readable mediums. A method includes maintaining a computer-aided-manufacturing (CAM) model (208) in a CAM environment (202) and numerically-controlled (NC) program (210) for an NC machine (212) that corresponds to the CAM model. The method receiving (302) a modification to the NC program in an NC system interface (204) and automatically identifying (306) a geometry of the CAM model that corresponds to the modification and linking the identified geometry to the modification. The method includes automatically modifying (310) the CAM model according to the modification to the NC program to produce an updated CAM model (404) and automatically generating (314) an updated NC program according to the updated CAM model. The method includes displaying (318), in the NC system interface, a preview (504) corresponding to the updated NC program.

## Description

### TECHNICAL FIELD

The present disclosure is directed, in general, to computer-aided design, visualization, and manufacturing systems (collectively, "CAM systems"), product lifecycle management ("PLM") systems, and similar systems, that manage data for products and other items (collectively, "Product Data Management" systems or PDM systems).

### BACKGROUND OF THE DISCLOSURE

CAM systems aid in designing products to be manufactured, and numerically-controlled (NC) machines physically manufacture products and components. Improved systems are desirable.

### SUMMARY OF THE DISCLOSURE

Various disclosed embodiments include systems and methods for part model generation and simulation and corresponding systems and computer-readable mediums. A method includes receiving a part model and creating at least one rigid body corresponding to the part model. The method includes creating at least one proxy body corresponding to the part model, including directly attaching at least one proxy body to at least one rigid body, wherein the proxy body represents a rigid body that is not part of the part model. The method includes simulating the part model by the data processing system according to the corresponding rigid bodies and proxy bodies.

The foregoing has outlined rather broadly the features and technical advantages of the present disclosure so that those skilled in the art may better understand the detailed description that follows. Additional features and advantages of the disclosure will be described hereinafter that form the subject of the claims. Those skilled in the art will appreciate that they may readily use the conception and the specific embodiment disclosed as a basis for modifying or designing other structures for carrying out the same purposes of the present disclosure. Those skilled in the art will also realize that such equivalent constructions do not depart from the spirit and scope of the disclosure in its broadest form.

Before undertaking the DETAILED DESCRIPTION below, it may be advantageous to set forth definitions of certain words or phrases used throughout this patent document: the terms "include" and "comprise," as well as derivatives thereof, mean inclusion without limitation; the term "or" is inclusive, meaning and/or; the phrases "associated with" and "associated therewith," as well as derivatives thereof, may mean to include, be included within, interconnect with, contain, be contained within, connect to or with, couple to or with, be communicable with, cooperate with, interleave, juxtapose, be proximate to, be bound to or with, have, have a property of, or the like; and the term "controller" means any device, system or part thereof that controls at least one operation, whether such a device is implemented in hardware, firmware, software, or some combination of at least two of the same. It should be noted that the functionality associated with any particular controller may be centralized or distributed, whether locally or remotely. Definitions for certain words and phrases are provided throughout this patent document, and those of ordinary skill in the art will understand that such definitions apply in many, if not most, instances to prior as well as future uses of such defined words and phrases. While some terms may include a wide variety of embodiments, the appended claims may expressly limit these terms to specific embodiments.

### BRIEF DESCRIPTION OF THE DRAWINGS

For a more complete understanding of the present disclosure, and the advantages thereof, reference is now made to the following descriptions taken in conjunction with the accompanying drawings, wherein like numbers designate like objects, and in which:
Figure 1 illustrates a block diagram of a data processing system in which an embodiment can be implemented;
Figure 2 illustrates a block diagram of logical components of a system in accordance with disclosed embodiments;
Figure 3 illustrates an example of a process in accordance with disclosed embodiments;
Figure 4 illustrates an example of a display interface for a CAM environment; and
Figure 5 illustrates an example of a display of NC system interface.

### DETAILED DESCRIPTION

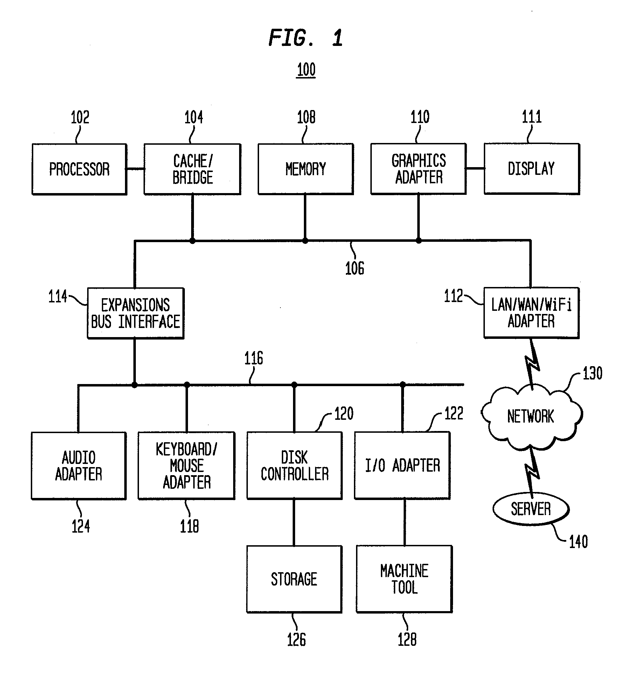

FIGURES 1 through 5, discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged device. The numerous innovative teachings of the present application will be described with reference to exemplary non-limiting embodiments.

NC programs are programs that control the operations of NC machines, including specific coding for movements and timing, and can direct the NC machine to perform the appropriate machining operations to manufacture some or all of a physical part from a work piece or "blank." NC programs can be generated by CAM systems.

CAM systems can be used to create and maintain three-dimensional models of the part to be manufactured. These models include the geometric model of the work piece, and can include a machining plan of CAM operations to be performed to machine the part. The CAM system maintains relationships between the CAM operations and the geometric elements of the work piece that are intended to be manufactured. Further, the CAM operations can include parameters describing the particular machining technology to be used. These CAM operations can be expressed in or converted to NC programs.

However, it is relatively unusual for unmodified, CAM-system-generated NC programs to be directly used in the actual machining process. In many work processes, only complex operations are programed with a CAM system and accordingly the simple operations are programed at the NC machine. In a typical case, program segments are added to the NC program, at the NC machine, to adapt the program to the machine or to target specific machine functions. In addition, coordinating NC programs for multiple operations can require some changes. In the process of adapting the original CAM-system-generated NC programs for actual use on the corresponding NC machine, experienced machine operators can optimize the parameters, operations, and all further aspects of the NC program.

When the NC program is being adapted, optimized, and otherwise modified, operations for the manufacturing of geometric elements are added on the NC machine tool. These operations are only administrated and accessible on the interface of the NC machine, but the modifications to the NC programs are never incorporated back into the CAM models. Disclosed embodiments include systems and methods for integrating and linking of NC-machine operations and programming modifications to the CAM system and the CAM model.

Figure 1 illustrates a block diagram of a data processing system in which an embodiment can be implemented, for example as a CAM data processing system or NC machine particularly configured by software or otherwise to perform the processes as described herein, and in particular as each one of a plurality of interconnected and communicating systems as described herein. The data processing system depicted includes a processor 102 connected to a level two cache/bridge 104, which is connected in turn to a local system bus 106. Local system bus 106 may be, for example, a peripheral component interconnect (PCI) architecture bus. Also connected to local system bus in the depicted example are a main memory 108 and a graphics adapter 110. The graphics adapter 110 may be connected to display 111.

Other peripherals, such as local area network (LAN) / Wide Area Network / Wireless (*e*.*g*. WiFi) adapter 112, may also be connected to local system bus 106. Expansion bus interface 114 connects local system bus 106 to input/output (I/O) bus 116. I/O bus 116 is connected to keyboard/mouse adapter 118, disk controller 120, and I/O adapter 122. Disk controller 120 can be connected to a storage 126, which can be any suitable machine usable or machine readable storage medium, including but not limited to nonvolatile, hard-coded type mediums such as read only memories (ROMs) or erasable, electrically programmable read only memories (EEPROMs), magnetic tape storage, and user-recordable type mediums such as floppy disks, hard disk drives and compact disk read only memories (CD-ROMs) or digital versatile disks (DVDs), and other known optical, electrical, or magnetic storage devices. I/O adapter 122 can be connected to communicate with and control a machine tool 128, such as a cutter, lathe, or other NC machine tool.

Also connected to I/O bus 116 in the example shown is audio adapter 124, to which speakers (not shown) may be connected for playing sounds. Keyboard/mouse adapter 118 provides a connection for a pointing device (not shown), such as a mouse, trackball, trackpointer, touchscreen, etc.

Those of ordinary skill in the art will appreciate that the hardware depicted in Figure 1 may vary for particular implementations. For example, other peripheral devices, such as an optical disk drive and the like, also may be used in addition or in place of the hardware depicted. The depicted example is provided for the purpose of explanation only and is not meant to imply architectural limitations with respect to the present disclosure.

A data processing system in accordance with an embodiment of the present disclosure includes an operating system employing a graphical user interface. The operating system permits multiple display windows to be presented in the graphical user interface simultaneously, with each display window providing an interface to a different application or to a different instance of the same application. A cursor in the graphical user interface may be manipulated by a user through the pointing device. The position of the cursor may be changed and/or an event, such as clicking a mouse button, generated to actuate a desired response.

One of various commercial operating systems, such as a version of Microsoft Windows™, a product of Microsoft Corporation located in Redmond, Wash. may be employed if suitably modified. The operating system is modified or created in accordance with the present disclosure as described.

LAN/WAN/Wireless adapter 112 can be connected to a network 130 (not a part of data processing system 100), which can be any public or private data processing system network or combination of networks, as known to those of skill in the art, including the Internet. Data processing system 100 can communicate over network 130 with a second system 140, which is also not part of data processing system 100, but can be implemented, for example, as a separate data processing system 100. In specific embodiments, data processing system 100 can be a CAM system as described herein and the second system 140 can be an NC machine system as described herein. In some embodiments, these systems can communicate directly rather than over network 130. In some embodiments, a single data processing system 100 can perform the functions of both the CAM system and the NC machine system as described herein.

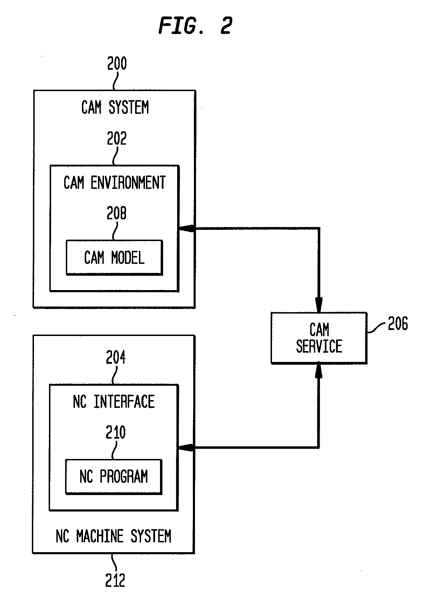

Figure 2 illustrates a block diagram of logical components of a system in accordance with disclosed embodiments. Fig. 2 illustrates a CAM environment 202, a CAM service 206, and an NC system interface 204.

The CAM environment 202 can be implemented on CAM system 200 by a data processing system 100 system using CAM software tools to allow users to design, edit, and display CAM data, generally illustrated as CAM model 208, and can perform other functions as described herein. The CAM model 208 can be a three-dimensional part model with associated data.

The CAM service 206 can modify CAM data according to the data received from the NC system interface 204 and can generate new NC programs or modify existing NC programs. CAM service 206 can communicate with both the CAM environment 202 and the NC system interface 204 as described herein.

The NC system interface 204 can include a program editor that displays CAM generated NC programs, generally illustrated as NC program 210, and can display NC programs with masks to represent the single operations.

One or more of the CAM environment 202, a CAM service 206, and an NC system interface 204 can be implemented, in some cases, in a data processing system 100. In some cases, the NC system interface 204 can be implemented on an NC machine system in communication with the CAM service 206, which can be implemented on the same system or a different system. CAM service 206 can be implemented on the same system or a different system from CAM environment 202. The NC machine system can be implemented as a data processing system 100 including machine tool 128 and other conventional NC machine components.

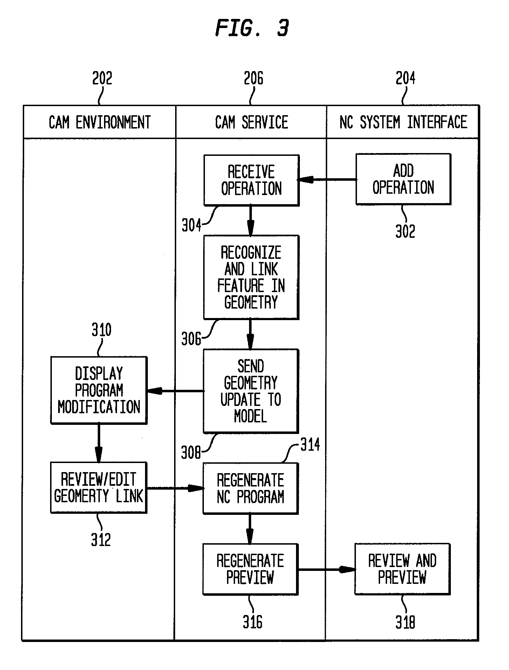

Figure 3 illustrates an example of a process in accordance with disclosed embodiments. Where the "system" is referred to in this process, it refers to the corresponding system(s) used to implement the CAM environment 202, CAM service 206, and NC system interface 204, and can be implemented using one or more data processing systems 100. The "user" refers to the user of the corresponding system at the time described. In the description below, "CAM model" may be used to refer to both a CAM-specific model and to a corresponding CAD design model.

In this example, it is assumed that CAM environment 202 stores and maintains a CAM model 208 comprising CAD/CAM modeled geometry. The NC system interface 204 for NC machine 212 stores and maintains an NC program 210 corresponding to the CAM model 208. In this process, the NC system interface 204 is used to edit, update, or otherwise modify the NC program 210; in this specific example, a new operation is being added to the NC program 210.

This exemplary process starts at 302 when a user adds an operation to the NC program which is received by the NC system interface 204. For example, the user can add an additional cutting operation or other operation that affects the part to be manufactured. Of course, any NC program modification can be used here.

The NC system interface 204 transmits the NC program modification to the CAM service 206, for example in a change file. The NC program modification can include a request to adapt the CAM model to reflect the NC program modification, to regenerate the NC program, or to update a preview of the part to be manufactured.

The CAM service receives the NC program modification at 304.

The system or the CAM service 206 can automatically identify one or more geometric features of the CAM model that correspond to the program modification, and link the modification to the corresponding CAM model geometry at 306, including any updates to the CAM model geometry required by the program modification. The corresponding CAM model geometry is the element that will be manufactured by the program modification. "Identifying" can include creating a new geometric feature for the CAM model that corresponds to the program modification.

The CAM service 206 can send the program modification, the links to corresponding CAM model geometry, and the updates to the CAM model geometry to the CAM environment 202 at 308.

At 310, the CAM environment displays the added operation or other program modification, preferably with a color markup, in the machining plan or on the CAM model geometry. This step can include automatically modifying the CAM model according to the modification to the NC program to produce an updated CAM model.

At 312, the CAM environment 202 can receive, from a user, any changes or updates to parameters for the program modification. The CAM environment 202 can also receive a user confirmation of the link to corresponding CAM model geometry as determined by the CAM service 206 or can receive instead a user selection of the corresponding CAM model geometry to be linked (for example if the automatic determination was incorrect). The CAM environment 202 can store the updated CAM model, including any changes, modifications, parameters, and links.

At 314, the CAM service 206 can automatically generate a new NC program corresponding to the updated CAM model. At 316, the CAM service 206 can also regenerate a preview view of the NC system operations to be performed. The CAM service 206 can transmit the new NC program and preview to the NC system interface 204.

At 318, such as the next time the NC program is opened at the NC system interface 204, the NC system interface displays the new preview view to the user so that the user can level and accept the new NC program. If the NC program is opened on the NC system interface 204 at the time the new version of the NC program is received, the user can be notified and asked if the new version shall be opened.

The following describes one non-limiting example of a process as disclosed. In a CAM environment 202, a CAM model based on a CAD model is created. The CAM environment 202 or the CAM service 206 can generate a corresponding NC program. The NC program is handed over from the process engineering to the manufacturing department for actual manufacture; the manufacturing department, in this example, actually operates the NC system, which controls one or more specific NC machines, and NC system interface 204.

At the machine NC system, the machine operator examines the NC program. In doing so he adapts the program to the machine and optimizes it with the background of his detailed technological knowledge using NC system interface 204. Thus also new operations are added to the NC program as well as existing operations are replaced by more convenient manufacturing operations.

The program editor on the NC system interface 204 provides the function that any changes on the NC program are transmitted to the CAM service 206 in a change file. The CAM service 206 opens the corresponding CAM model on every change file and adds the new operations to the machining plan. On the information of the type and the geometry relevant parameters of the added operations the CAM service 206 determines if a corresponding geometry feature in the CAM model can be linked to the added operation in the CAM model.

Subsequently the CAM engineer views the CAM model in the CAM environment 202. The new added operations can be highlighted, displayed in a different color, or otherwise brought to the attention of the user. The user can open the new operations and verify the linkage of the operations to the geometry features of the work piece and complete the parameters on the operation, if needed. After all parameters are set completely and consistently, the user saves the CAM model.

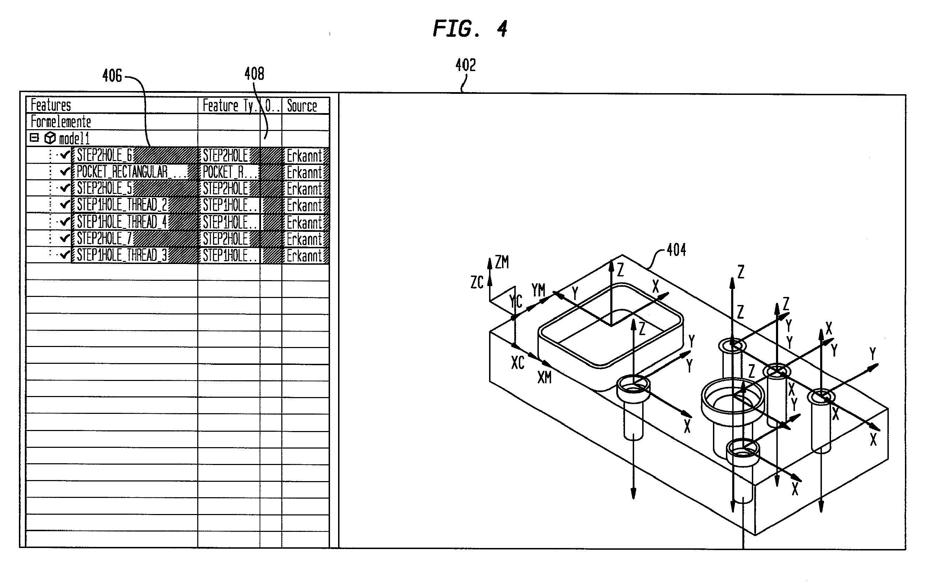

Figure 4 illustrates an example of a display interface 402 for a CAM environment 202. This display interface 402 shows a three-dimensional CAM model 404. This display interface 402 shows a list of geometric features 406 of the CAM model 404 along with associated parameters 408. In this example, the CAM model 404, features 406, and parameters 408 are highlighted as operations of the NC program that had been added on NC system interface 204.

CAM service 206 then generates, for the new version of the CAM model, the corresponding NC program and any preview pictures for any CAM operation.

At the machine, the machine operator is enabled to take over the NC program with the new manufacturing operations and the parameters determined on the CAM model and to evaluate the machining operations with the preview pictures using the NC system interface 204.

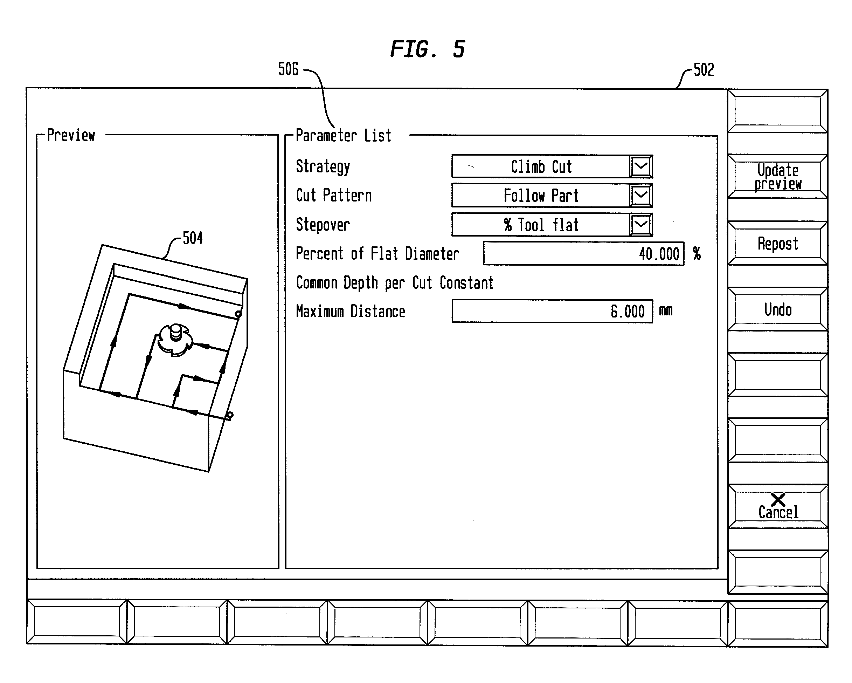

Figure 5 illustrates an example of a display 502 of NC system interface 204. In this example a preview 504 of the CAM model is shown, using a user-specified mask. The user can use the preview 504 and the associated parameters 506 to verify that the updated NC program will function as intended.

The masks used for the display 502 of NC system interface 204 can use the same parameter names and be linked in their configuration to the parameters in the CAM environment 202. In this way, the user can specify, via the masks, exactly which tools, parameters, operations, and other aspects of the NC program or simulation will be displayed at any time. A system as disclosed herein can use the xml based configurations of UI layout of the QT user interface and application framework of Digia Oyj, Valimotie 21, 00380 Helsinki Finland (http://qt.digia.com/), and can embed controls programmed in C++. A system as disclosed herein can use a customizable HMI as provided in the Siemens SINUMERIK family of products, and can use xml or ini-style configurations to design masks for the HMI. Of course, other implementations can use other interface design products, frameworks, programming languages, filetypes, or file formats.

Disclosed embodiments provide a distinct technical advantage, particularly in automatically linking the modifications of the NC program to the CAM model geometry. This is particularly useful when the NC system interface and CAM environment are implemented on different physical machines, so that the NC program (and its preview) are kept synchronized with the CAD/CAM model even when the machine operator updates the NC program.

There is also a distinct advantage in that the NC machine operator can update the NC program according to his own expertise or the requirements of the specific machine, and the CAD/CAM model will be automatically updated without the NC machine operator being required to also be familiar with the CAM environment itself.

Further, the automatic update, synchronization, and preview processes described herein make it easy for both the CAM engineer and the NC machine operator to identify inconsistent, inconvenient, or incomplete CAM parameter sets in the interaction between the process engineering department and the manufacturing department.

Non-limiting examples of suitable NC machines that can be used as described herein include the SINUMERIK family of machines produced by Siemens, including the SINUMERIK 840D sl machine. Other machines can include multi-axis milling and turning machines such as those produced by HELLER Machine Tools L.P. INDEX-Werke GmbH & Co. KG Hahn & Tessky. An NC system interface can be implemented, as a non-limiting example, by the SINUMERIK OPERATE HMI and the SINUMERIK OPERATE data interface products by produced by Siemens. Any of these products, or other NC systems and interfaces, can be modified to perform actions as described herein.

Those skilled in the art will recognize that, for simplicity and clarity, the full structure and operation of all data processing systems suitable for use with the present disclosure is not being depicted or described herein. Instead, only so much of a data processing system as is unique to the present disclosure or necessary for an understanding of the present disclosure is depicted and described. The remainder of the construction and operation of data processing system 100 may conform to any of the various current implementations and practices known in the art.

It is important to note that while the disclosure includes a description in the context of a fully functional system, those skilled in the art will appreciate that at least portions of the mechanism of the present disclosure are capable of being distributed in the form of instructions contained within a machine-usable, computer-usable, or computer-readable medium in any of a variety of forms, and that the present disclosure applies equally regardless of the particular type of instruction or signal bearing medium or storage medium utilized to actually carry out the distribution. Examples of machine usable/readable or computer usable/readable mediums include: nonvolatile, hard-coded type mediums such as read only memories (ROMs) or erasable, electrically programmable read only memories (EEPROMs), and user-recordable type mediums such as floppy disks, hard disk drives and compact disk read only memories (CD-ROMs) or digital versatile disks (DVDs).

Although an exemplary embodiment of the present disclosure has been described in detail, those skilled in the art will understand that various changes, substitutions, variations, and improvements disclosed herein may be made without departing from the spirit and scope of the disclosure in its broadest form.

None of the description in the present application should be read as implying that any particular element, step, or function is an essential element which must be included in the claim scope: the scope of patented subject matter is defined only by the allowed claims. Moreover, none of these claims are intended to invoke paragraph six of 35 USC §112 unless the exact words "means for" are followed by a participle.

Further Embodiments
1. A method performed by at least one data processing system (100) and comprising:
   (i) maintaining a computer-aided-manufacturing (CAM) model (208) in a CAM environment (202);
   (ii) maintaining a numerically-controlled (NC) program (210) for an NC machine (212) that corresponds to the CAM model;
   (iii) receiving (302) a modification to the NC program in an NC system interface (204);
   (iv) automatically identifying (306) a geometry of the CAM model that corresponds to the modification and linking the identified geometry to the modification;
   (v) automatically modifying (310) the CAM model according to the modification to the NC program to produce an updated CAM model (404);
   (vi) automatically generating (314) an updated NC program according to the updated CAM model; and
   (vii) displaying (318), in the NC system interface, a preview (504) corresponding to the updated NC program.
2. The method of embodiment 1, wherein the CAM environment is implemented on a CAM data processing system (200) and the NC system interface is implemented on a separate NC machine system (212) in communication with the CAM data processing system.
3. The method of embodiment 1, wherein the modification to the NC program (210) is received from an NC machine system operator.
4. The method of embodiment 1, wherein a CAM service (206) receives the modification to the NC program (210) from the NC system interface (204) and performs acts (iv), (v), and (vi).
5. The method of embodiment 1, wherein identifying a geometry of the CAM model that corresponds to the modification includes creating a new geometric feature in the CAM model.
6. The method of embodiment 1, wherein the updated CAM model (404) is displayed to a user in the CAM environment (202) for verification of the linked geometry and modification.
7. The method of embodiment 1, wherein the CAM environment also receives (312) parameters for the modification from a user.
8. At least one data processing system (100) comprising:
   a processor (102); and
   an accessible memory (108), the data processing system particularly configured to
      (i) maintain a computer-aided-manufacturing (CAM) model (208) in a CAM environment (202);
      (ii) maintain a numerically-controlled (NC) program (210) for an NC machine (212) that corresponds to the CAM model;
      (iii) receive (302) a modification to the NC program in an NC system interface (204);
      (iv) automatically identify (306) a geometry of the CAM model that corresponds to the modification and linking the identified geometry to the modification;
      (v) automatically modify (310) the CAM model according to the modification to the NC program to produce an updated CAM model (404);
      (vi) automatically generate (314) an updated NC program according to the updated CAM model; and
      (vii) display (318), in the NC system interface, a preview (504) corresponding to the updated NC program.
9. The data processing system of embodiment 8, wherein the CAM environment is implemented on a CAM data processing system (200) and the NC system interface is implemented on a separate NC machine system (212) in communication with the CAM data processing system.
10. The data processing system of embodiment 8, wherein the modification to the NC program (210) is received from an NC machine system operator.
11. The data processing system of embodiment 8, wherein a CAM service (206) receives the modification to the NC program (210) from the NC system interface (204) and performs acts (iv), (v), and (vi).
12. The data processing system of embodiment 8, wherein identifying a geometry of the CAM model that corresponds to the modification includes creating a new geometric feature in the CAM model.
13. The data processing system of embodiment 8, wherein the updated CAM model (404) is displayed to a user in the CAM environment (202) for verification of the linked geometry and modification.
14. The data processing system of embodiment 8, wherein the CAM environment also receives (312) parameters for the modification from a user.
15. A non-transitory computer-readable medium (126) encoded with executable instructions that, when executed, cause one or more data processing systems (100) to:
   (i) maintain a computer-aided-manufacturing (CAM) model (208) in a CAM environment (202);
   (ii) maintain a numerically-controlled (NC) program (210) for an NC machine (212) that corresponds to the CAM model;
   (iii) receive (302) a modification to the NC program in an NC system interface (204);
   (iv) automatically identify (306) a geometry of the CAM model that corresponds to the modification and linking the identified geometry to the modification;
   (v) automatically modify (310) the CAM model according to the modification to the NC program to produce an updated CAM model (404);
   (vi) automatically generate (314) an updated NC program according to the updated CAM model; and
   (vii) display (318), in the NC system interface, a preview (504) corresponding to the updated NC program.
16. The computer-readable medium of embodiment 15, wherein the CAM environment is implemented on a CAM data processing system (200) and the NC system interface is implemented on a separate NC machine system (212) in communication with the CAM data processing system.
17. The computer-readable medium of embodiment 15, wherein the modification to the NC program (210) is received from an NC machine system operator.
18. The computer-readable medium of embodiment 15, wherein a CAM service (206) receives the modification to the NC program (210) from the NC system interface (204) and performs acts (iv), (v), and (vi).
19. The computer-readable medium of embodiment 15, wherein identifying a geometry of the CAM model that corresponds to the modification includes creating a new geometric feature in the CAM model.
20. The computer-readable medium of embodiment 15, wherein the updated CAM model (404) is displayed to a user in the CAM environment (202) for verification of the linked geometry and modification, and wherein the CAM environment also receives (312) parameters for the modification from a user.

## Claims

1. A method performed by at least one data processing system (100) and comprising:
(i) maintaining a computer-aided-manufacturing (CAM) model (208) in a CAM environment (202);
(ii) maintaining a numerically-controlled (NC) program (210) for an NC machine (212) that corresponds to the CAM model;
(iii) receiving (302) a modification to the NC program in an NC system interface (204);
(iv) automatically identifying (306) a geometry of the CAM model that corresponds to the modification and linking the identified geometry to the modification;
(v) automatically modifying (310) the CAM model according to the modification to the NC program to produce an updated CAM model (404);
(vi) automatically generating (314) an updated NC program according to the updated CAM model; and
(vii) displaying (318), in the NC system interface, a preview (504) corresponding to the updated NC program.

2. The method of claim 1, wherein the CAM environment is implemented on a CAM data processing system (200) and the NC system interface is implemented on a separate NC machine system (212) in communication with the CAM data processing system.

3. The method according to any of the preceding claims, wherein the modification to the NC program (210) is received from an NC machine system operator.

4. The method according to any of the preceding claims, wherein a CAM service (206) receives the modification to the NC program (210) from the NC system interface (204) and performs acts (iv), (v), and (vi).

5. The method according to any of the preceding claims, wherein identifying a geometry of the CAM model that corresponds to the modification includes creating a new geometric feature in the CAM model.

6. The method according to any of the preceding claims, wherein the updated CAM model (404) is displayed to a user in the CAM environment (202) for verification of the linked geometry and modification.

7. The method according to any of the preceding claims, wherein the CAM environment also receives (312) parameters for the modification from a user.

8. At least one data processing system (100) comprising:
a processor (102); and
an accessible memory (108), the data processing system particularly configured to
(i) maintain a computer-aided-manufacturing (CAM) model (208) in a CAM environment (202);
(ii) maintain a numerically-controlled (NC) program (210) for an NC machine (212) that corresponds to the CAM model;
(iii) receive (302) a modification to the NC program in an NC system interface (204);
(iv) automatically identify (306) a geometry of the CAM model that corresponds to the modification and linking the identified geometry to the modification;
(v) automatically modify (310) the CAM model according to the modification to the NC program to produce an updated CAM model (404);
(vi) automatically generate (314) an updated NC program according to the updated CAM model; and
(vii) display (318), in the NC system interface, a preview (504) corresponding to the updated NC program.

9. The data processing system of claim 8, wherein the CAM environment is implemented on a CAM data processing system (200) and the NC system interface is implemented on a separate NC machine system (212) in communication with the CAM data processing system.

10. The data processing system according to any of the preceding system-based claims, wherein the modification to the NC program (210) is received from an NC machine system operator.

11. The data processing system according to any of the preceding system-based claims, wherein a CAM service (206) receives the modification to the NC program (210) from the NC system interface (204) and performs acts (iv), (v), and (vi).

12. The data processing system according to any of the preceding system-based claims, wherein identifying a geometry of the CAM model that corresponds to the modification includes creating a new geometric feature in the CAM model.

13. The data processing system according to any of the preceding system-based claims , wherein the updated CAM model (404) is displayed to a user in the CAM environment (202) for verification of the linked geometry and modification.

14. The data processing system according to any of the preceding system-based claims, wherein the CAM environment also receives (312) parameters for the modification from a user.

15. A non-transitory computer-readable medium (126) encoded with executable instructions that, when executed, cause one or more data processing systems (100) to perform a method according to any of the claims 1 to 7.
